# EUROPÄISCHE PATENTSCHRIFT

(11) **EP 1 941 285 B1**
(45) Veröffentlichungstag und Bekanntmachung des Hinweises auf die Patenterteilung: **28.11.2012**
(21) Anmeldenummer: 05806825.5
(22) Anmeldetag: 25.10.2005
(51) Int. Cl.: G01R 19/25

(54) **VERFAHREN ZUM ERZEUGEN EINES DATENSATZES UND FELDGERÄT SOWIE SYSTEM ZUM ERFASSEN DER ELEKTROENERGIEQUALITÄT EINES ENERGIEVERSORGUNGSNETZES**
METHOD FOR GENERATING A DATA RECORD, AND FIELD DEVICE AND SYSTEM FOR DETECTING THE QUALITY OF ELECTRICAL POWER FROM A POWER SUPPLY SYSTEM
PROCÉDÉ D'ÉLABORATION D'UNE SÉRIE DE DONNÉES ET APPAREIL DE TERRAIN AINSI QUE SYSTÈME DE DÉTECTION DE LA QUALITÉ ÉLECTRO-ÉNERGÉTIQUE D'UN RÉSEAU D'ALIMENTATION EN ÉNERGIE

(43) Veröffentlichungstag der Anmeldung: 09.07.2008
(73) Patentinhaber: SIEMENS AKTIENGESELLSCHAFT, 80333 München (DE)
(72) Erfinder: JURISCH Andreas, 16727 Schwante (DE)
(86) Internationale Anmeldenummer: PCT/DE2005/001937
(87) Internationale Veröffentlichungsnummer: WO 2007/048363

(56) Entgegenhaltungen:
- US-A1- 2002 145 517
- SCHMARANZ R ET AL: "Automated power system event detector and classifier" HARMONICS AND QUALITY OF POWER, 2004. 11TH INTERNATIONAL CONFERENCE ON LAKE PLACID, NY, USA 12-15 SEPT. 2004, PISCATAWAY, NJ, USA,IEEE, US, 12. September 2004 (2004-09-12), Seiten 801-806, XP010777348 ISBN: 0-7803-8746-5
- IL-YOP CHUNG ET AL: "Development of power quality diagnosis system for power quality improvement" 2003 IEEE POWER ENGINEERING SOCIETY GENERAL MEETING. CONFERENCE PROCEEDINGS. TORONTO, ONTARIO, CANADA, JULY 13 - 17, 2003, IEEE POWER ENGINEERING SOCIETY, NEW YORK, NY : IEEE, US, Bd. VOL. 4 OF 4, 2003, Seiten 1256-1261, XP010687261 ISBN: 0-7803-7989-6
- SIEMENS: "Digitaler Störschreiber SIMEAS R" POWER QUALITY, KATALOG SR 10.1.1, 2004, Seiten 1-28, XP007900878 in der Anmeldung erwähnt

## Beschreibung

Die Erfindung betrifft ein Verfahren zum Erzeugen eines Datensatzes, der eine Abweichung von an einer Messstelle eines Energieversorgungsnetzes vorliegenden Wechselstrom- und/oder Wechselspannungswerten von ihrem erwartungsgemäßen zeitlichen Verlauf angibt, wobei bei dem Verfahren folgende Schritte durchgeführt werden: Aufnehmen von die Wechselstrom- und/oder Wechselspannungswerte an der Messstelle des Energieversorgungsnetzes angebenden Messwerten. Die Erfindung betrifft auch ein Feldgerät zum Erfassen der Elektroenergiequalität an einer Messstelle eines Energieversorgungsnetzes mit einer Messeinrichtung zum Erfassen von einen Wechselstrom und/oder eine Wechselspannung angebenden Messwerten und einer Recheneinheit zum Bestimmen eines Mittelwertes der aufgenommenen Messwerte sowie ein System mit mehreren solchen Feldgeräten.

In elektrischen Energieversorgungsnetzen werden so genannte Störschreiber eingesetzt, um die Qualität der von dem Energieversorgungsnetz gelieferten elektrischen Energie zu überwachen. Störschreiber können in diesem Fall als so genannte Feldgeräte ausgebildet sein, die in der Nähe einer Messstelle des Energieversorgungsnetzes angeordnet sind. Die Qualität der elektrischen Energie an dieser Messstelle wird hierbei an bestimmten Qualitätsparametern festgemacht, wie beispielsweise dem Anteil von Abweichungen der zeitlichen Verläufe von Strom- und Spannungswerten von ihrem erwartungsgemäßen Verlauf hinsichtlich Frequenz, Amplitude und Phase. Auch der Anteil von Oberwellen, die Stabilität eines Mittelwertes der Strom- bzw. Spannungswerte und die übertragene Leistung können solche Qualitätsparameter darstellen.

Störschreiber sind beispielsweise aus dem Siemens Katalog "Digitaler Störschreiber SIMEAS R, Power Quality Katalog SR 10.1.1, 2004 bekannt. Zum Bestimmen der Elektroenergiequalität in einem Energieversorgungsnetz werden von dem bekannten Störschreiber Wechselstrom- und Wechselspannungswerte an der Messstelle des elektrischen Energieversorgungsnetzes erfasst und diesen proportionale Messwerte erzeugt. Daraus werden die genannten Qualitätsparameter gebildet. Abweichungen der Qualitätsparameter von ihrem gewünschten Verlauf werden in Ereignisprotokollen abgespeichert und können zur Auswertung an externe Geräte wie beispielsweise Auswertecomputer übermittelt werden. Mit Hilfe eines solchen Auswertecomputers kann anhand des Ereignisprotokolls der Grad der Elektroenergiequalität des Energieversorgungsnetzes bestimmt werden. Beispielsweise kann hierzu untersucht werden, ob der Verlauf der Qualitätsparameter innerhalb der von bestimmten Normen, wie beispielsweise der EN 50160, geforderten Bereiche liegt.

Die Auswertung der ermittelten Qualitätsparameter kann ferner durch bestimmte Methoden unterstützt werden, mit denen die Auswirkungen von Abweichungen der Qualitätsparameter abgeschätzt werden können. Hierzu können beispielsweise die Beträge von positiven Abweichungen eines gemessenen Spannungsmittelwertes (so genannte "Swells" = Berge) oder bzw. negativen Abweichungen dieses Mittelwertes (so genannte "Sags" = Täler) über der Dauer der jeweiligen Abweichung in einem Diagramm aufgetragen werden. Anhand beispielsweise vom ITIC (Information Technology Industries Council) vorgegebener Kennlinien kann bestimmt werden, ob die gemessene Abweichung insbesondere für Geräte der Informationstechnik schädlich ist.

Darüber hinaus sind Verfahren und Feldgeräte zum Erfassen der Elektroenergiequalität auch beispielsweise aus R. Schmaranz et al. "Automated power system event detector and classifier", HARMONICS and QUALITY OF POWER, 2004, 11th International Conference on Lake Placid, NY, USA, 12.-15. Sept. 2004, Piscataway, NJ, USA, IEEE, US, 12.09.2004, Seiten 801-806, XP010777348, ISBN: 0-7803-8746-5 und aus IL-YOP CHUNG et al. "Development of power quality diagnosis system for power quality improvement", 2003 IEEE Power Engineering Society General Meeting, Conference proceedings, Toronto, Ontario, Canada, 13.-17. Juli 2003, IEEE Power Engineering Society, New York, NY: IEEE, US, Bd. Vol. 4 of 4, 2003, Seiten 1256-1261, XP010687261, ISBN: 0-7803-7989-6 bekannt.

Die Aufgabe der Erfindung besteht darin, ein Verfahren und ein Feldgerät bzw. ein System anzugeben, mit dem Abweichungen der Elektroenergiequalität in einem Energieversorgungsnetz noch genauer spezifiziert werden können.

Zur Lösung dieser Aufgabe hinsichtlich des Verfahrens wird ein Verfahren der eingangs genannten Art vorgeschlagen, bei dem die folgenden weiteren Schritte durchgeführt werden: Erzeugen eines Ereignissignals, wenn die Messwerte von ihrem erwartungsgemäßen zeitlichen Verlauf abweichen; wobei die Messwerte jeweils während einer Mittelungsdauer aufgenommen werden und aus den während der Mittelungsdauer aufgenommenen Messwerten ein Mittelwert gebildet wird und eine Differenz zwischen diesem Mittelwert und einem Erwartungswert gebildet wird, wobei der Erwartungswert einen erwarteten Wert des Mittelwertes angibt, der hinsichtlich dem aktuellen Mittelwert zeitlich vorausgegangener Mittelwerte unter Nutzung eines durch elektronische oder digitale Filter implementierten Signalmodells mit einem Gleichspannungsanteil und einem exponentiellen Anteil bestimmt worden ist, und das eine Abweichung des Mittelwertes angebende Ereignissignal erzeugt wird, wenn die Differenz einen vorgegebenen Schwellenwert übersteigt, im Falle eines vorliegenden Ereignissignals Ermitteln eines Parametersatzes einen Zustand des Energieversorgungsnetzes an der Messstelle beschreibender Zustands-Parameter aus den Messwerten und diesen Messwerten während einer vorgebbaren Ereignis-Zeitdauer folgenden weiteren Messwerten und Zuordnen zumindest einiger Zustands-Parameter des Parametersatzes zu einer zugehörigen, eine Ursache der Abweichung angebenden Ursachenzeichenfolge und Erzeugen des Datensatzes aus zumindest dem Parametersatz und der Ursachenzeichenfolge.

Der wesentliche Vorteil des erfindungsgemäßen Verfahrens besteht darin, dass hierdurch nicht nur die bloßen Zustands-Parameter erzeugt werden, die den momentanen Zustand des elektrischen Energieversorgungsnetzes während einer Abweichung beschreiben, sondern auch ein Datensatz ausgegeben wird, mit dem anhand der Ursachenzeichenfolge die Ursache der detektierten Abweichung angegeben wird. Auf diese Weise kann vom Betreiber des elektrischen Energieversorgungsnetzes bedeutend schneller eine Fehlerquelle im elektrischen Energieversorgungsnetz, die zu der Abweichung geführt hat, bestimmt werden. Gegebenenfalls können zeitnah geeignete Maßnahmen zur Beseitigung der Fehlerquelle getroffen werden. Mögliche Ursachen, die zu einer Abweichung der Zustands-Parameter führen können, sind beispielsweise Fehler (z.B. Kurzschlüsse), das Starten von Elektromotoren, eine Inbetriebnahme von Transformatoren, sich fortsetzende Fehler oder selbstverlöschende Fehler. Hierbei ist zu bemerken, dass es sich bei den Zustands-Parametern sowohl um konkrete berechnete Werte, wie z.B. eine Abweichung der Frequenz der gemessenen Messwerte, als auch um eher beschreibende Werte, wie z.B. die Angabe, dass Oberwellen überhaupt vorhanden sind, handeln kann. Mit dem erfindungsgemäßen Verfahren kann eine Abweichung besonders sicher detektiert und das Ereignissignal erzeugt werden. Ein Mittelwert kann in diesem Sinne z.B. ein so genannter RMS-Wert (root mean square) oder ein Effektivwert der aufgenommenen Messwerte sein.

Die Mittelungsdauer kann in diesem Zusammenhang beispielsweise eine halbe Schwingungsperiode des gemessenen Wechselstromes oder der gemessenen Wechselspannung betragen. So werden der Mittelwertbildung einerseits ausreichend viele Messwerte als Basis bereitgestellt und andererseits kann verhältnismäßig schnell ein Ergebnis bestimmt werden.

Gemäß einer weiteren vorteilhaften Weiterbildung des erfindungsgemäßen Verfahrens ist vorgesehen, dass zum Zuordnen der Zustands-Parameter zu der Ursachenzeichenfolge eine elektronische Datenbank verwendet wird, in der jeweils einer Ursachenzeichenfolge ein dazugehörender Vergleichssatz von Zustands-Parametern zugeordnet ist, und der Datensatz aus derjenigen Ursachenzeichenfolge erzeugt wird, deren zugeordneter Vergleichssatz mit dem ermittelten Parametersatz übereinstimmt.

Auf diese Weise kann besonders einfach dem Parametersatz eine entsprechende Ursachenzeichenfolge zugeordnet werden. Hierzu weist die elektronische Datenbank Vergleichssätze von Zustands-Parametern auf, denen Ursachenzeichenfolgen zugeordnet sind. Die Ursachenzeichenfolge besteht beispielsweise aus einer String-Variablen, die eine Bezeichnung der Ursache einer Abweichung zum Inhalt hat, z.B. "Start eines Elektromotors". Sie kann aber auch lediglich eine beliebige Abfolge von Zeichen enthalten, aus der dann eine für den Menschen verständliche Mitteilung gewonnen wird. Beim Vergleich des Parametersatzes der tatsächlich vorliegenden Zustands-Parameter mit den einzelnen Vergleichssätzen derjenigen Zustands-Parameter aus der elektronischen Datenbank wird eine Übereinstimmung des Parametersatzes mit einem Vergleichssatz abgeprüft, und bei vorliegender Übereinstimmung die zu der Abweichung passende Ursachenzeichenfolge aus der Datenbank ausgelesen.

Eine weitere vorteilhafte Ausführungsform des erfindungsgemäßen Verfahrens sieht vor, dass der Parametersatz auch harmonische Schwingungen der Grundfrequenz der Messwerte angibt. Hier bei kann wie erwähnt eine konkrete Angabe derjenigen aufgetretenen Oberschwingung erfolgen oder auch lediglich die Angabe, dass eine solche Oberschwingung vorliegt. Ferner kann vorgesehen sein, dass bei einem dreiphasigen Energieversorgungsnetz der Parametersatz auch symmetrische Komponenten der Messwerte angibt. Symmetrische Komponenten sind die Nullkomponente, die Mitkomponente und die Gegenkomponente im dreiphasigen System. Wiederum kann zur Angabe der symmetrischen Komponenten entweder eine konkrete Berechnung der einzelnen Komponenten durchgeführt werden oder lediglich eine Angabe gemacht werden, dass sich das Energieversorgungsnetz an der Messstelle beispielsweise in einem unsymmetrischen Zustand befindet (die Nullkomponente ist in diesem Fall ungleich Null).

Gemäß einer weiteren vorteilhaften Ausführungsform des erfindungsgemäßen Verfahrens ist vorgesehen, dass eine Ereignis-Zeitdauer bestimmt wird, während der die Abweichung vorliegt, und der Parametersatz auch die Ereignis-Zeitdauer angibt. Eine solche Ereignis-Zeitdauer ist beispielsweise für spätere Analysen der Abweichungen hilfreich.

Eine weitere vorteilhafte Ausführungsform des erfindungsgemäßen Verfahrens sieht vor, dass unter Verwendung zumindest einiger Zustands-Parameter des Parametersatzes eine eine Auswirkung der Abweichung angebende Auswirkungs-Zeichenfolge erzeugt wird und der Datensatz unter Berücksichtigung der Auswirkungs-Zeichenfolge erzeugt wird. Beispielsweise kann hierfür die eingangs erwähnte Methode der ITIC-Kennlinien verwendet werden, gemäß der anhand eines Diagramms, in dem der Betrag der Abweichung des Mittelwertes der Spannungsmesswerte über der Zeitdauer der Abweichung aufgetragen ist, der Grad der Abweichung bestimmt werden kann. Hieran kann die Schädlichkeit der Abweichungen für angeschlossene elektrische Geräte ermittelt werden.

Eine weitere vorteilhafte Ausführungsform des erfindungsgemäßen Verfahrens sieht schließlich vor, dass das Verfahren an mehreren Messstellen des Energieversorgungsnetzes durchgeführt wird und die an den einzelnen Messstellen erzeugten Datensätze zu einem Gesamt-Datensatz zusammengefasst werden. Auf diese Weise kann besonders einfach ein Gesamtüberblick über mehrere Messstellen des elektrischen Energieversorgungsnetzes erlangt werden. Der Gesamtdatensatz kann beispielsweise an eine Netzleitstelle übertragen werden, in der das elektrische Energieversorgungsnetz überwacht und gesteuert wird.

Hinsichtlich des Feldgerätes wird die oben genannte Aufgabe durch ein Feldgerät der eingangs genannten Art gelöst, mit einer Schätzeinrichtung zur Bildung eines Erwartungswertes, der einen erwarteten Wert des Mittelwertes angibt, der hinsichtlich dem aktuellen Mittelwert zeitlich vorausgegangener Mittelwerte unter Nutzung eines durch elektronische oder digitale Filter implementierten Signalmodells mit einem Gleichspannungsanteil und einem exponentiellen Anteil bestimmt worden ist, einer Ereigniserkennungseinrichtung, die bei einer Abweichung des Mittelwertes von dem Erwartungswert ein Ereignissignal erzeugt, einer Parameterberechnungseinrichtung, die bei vorliegendem Ereignissignal einen Parametersatz von Zustands-Parametern aus den Messwerten und den diesen Messwerten während einer vorgebbaren Messdauer folgenden weiteren Messwerten bestimmt, wobei die Zustands-Parameter den Zustand des Energieversorgungsnetzes an der Messstelle angeben, einer Ursachenerkennungseinheit, die bei vorliegender Abweichung dem Parametersatz eine eine Ursache der Abweichung angebende Ursachenzeichenfolge zuordnet und einer Ausgabeeinheit, die einen Datensatz ausgibt, die einen Datensatz ausgibt, der unter Berücksichtigung zumindest einiger Zustands-Parameter des Parametersatzes und der Ursachenzeichenfolge gebildet ist.

Mit dem erfindungsgemäßen Feldgerät kann auf einfache Weise eine Ursachenzeichenfolge ermittelt werden, die eine mögliche Ursache für die Abweichung der Zustandsparameter von ihren erwarteten Werten angibt. Auf diesem Weg kann dem Betreiber des Energieversorgungsnetzes eine Möglichkeit gegeben werden, Fehlerquellen in dem Energieversorgungsnetz schnell zu erkennen und ggf. zu beseitigen. Mit dem erfindungsgemäßen Feldgerät kann anhand einer einfachen Mittelwertbildung auf eine Abweichung geschlossen werden.

Außerdem besteht eine weitere vorteilhaft Ausführungsform des erfindungsgemäßen Feldgerätes darin, dass die Ursachenerkennungseinheit eine elektronische Datenbank aufweist, in der jeweils einer Ursachenzeichenfolge ein dazugehörender Vergleichssatz von Zustands-Parametern zugeordnet ist. Über die Datenbank kann vergleichsweise einfach eine Zuordnung der Ursachenzeichenfolge zu den entsprechenden Zustands-Parametern des Parametersatzes erfolgen.

Eine weitere vorteilhafte Ausführungsform des erfindungsgemäßen Feldgerätes besteht darin, dass das Feldgerät eine Auswirkungserkennungseinrichtung aufweist, die anhand zumindest einiger der Zustands-Parameter eine eine Auswirkung der Abweichung angebende Auswirkungs-Zeichenfolge erzeugt. Auf diese Weise kann neben der Ursache auch eine Auswirkung der erkannten Abweichung mit dem erzeugten Datensatz ausgegeben werden. Eine Auswirkung kann beispielsweise mit den oben erläuterten ITIC-Kennlinien erfolgen. Hierdurch wird der Betreiber des elektrischen Energieversorgungsnetzes mit umfassenden Informationen über die aufgetretenen Abweichungen versorgt.

Eine weitere vorteilhafte Ausführungsform des erfindungsgemäßen Feldgerätes sieht außerdem vor, dass die Ausgabeeinheit des Feldgerätes eine Datenschnittstelle aufweist, über die die der Datensatz ausgegeben wird. Vorteilhafterweise kann diese Datenschnittstelle eine IP-fähige Schnittstelle, z. B. eine Ethernet-Schnittstelle sein. Hierdurch ist es möglich, das erfindungsgemäße Feldgerät in ein IP-fähiges Netzwerk einzubinden. Ein IP-fähiges Netzwerk ist ein solches Netzwerk, in dem Datentelegramme nach dem IP-Protokoll übermittelt werden können. Dies ist z. B. ein Ethernetnetzwerk, in dem Daten beispielsweise gemäß dem Standard IEC 61850 übertragen werden können.

Die oben genannte Aufgabe wird auch durch ein System zum Erfassen der Elektroenergiequalität eines Energieversorgungsnetzes gelöst mit mehreren Feldgeräten gemäß einem der Ansprüche 9 bis 14, wobei die Feldgeräte über ein Kommunikationsnetzwerk miteinander verbunden sind. Hierdurch können die einzelnen Feldgeräte sehr einfach erkennen, ob auch bei anderen Messstellen des elektrischen Energieversorgungsnetzes Abweichungen erkannt worden sind. Ebenfalls ist es möglich, alle von den elektrischen Feldgeräten erzeugten und an das Kommunikationsnetzwerk abgegebenen Datensätze zu einem Gesamtdatensatz zu verbinden, der einen Überblick über den Zustand des gesamten elektrischen Energieversorgungsnetzes gibt. Vorteilhafterweise kann das Kommunikationsnetzwerk ein IP-fähiges Netzwerk, z. B. ein Ethernet-Netzwerk sein, in dem beispielsweise gemäß dem Standard IEC 61850 Daten ausgetauscht werden.

Vorteilhafterweise kann ferner eine zentrale Datenverarbeitungseinrichtung mit dem Kommunikationsnetzwerk in Verbindung stehen. Über die zentrale Datenverarbeitungseinrichtung kann eine Anzeige und Auswertung der einzelnen Datensätze oder eines Gesamtdatensatzes vorgenommen werden.

Zur weiteren Erläuterung der Erfindung sind in
- Figur 1: ein Ausführungsbeispiel eines Systems aus mehreren Feldgeräten zum Erfassen der Elektroenergiequalität eines Energieversorgungsnetzes, in
- Figur 2: ein Ausführungsbeispiel eines elektrischen Feldgerätes zum Erfassen der Elektroenergiequalität eines Energieversorgungsnetzes und in
- Figur 3: drei Diagramme zum Erläutern der Funktionsweise der Erzeugung eines Ereignissignals
gezeigt.

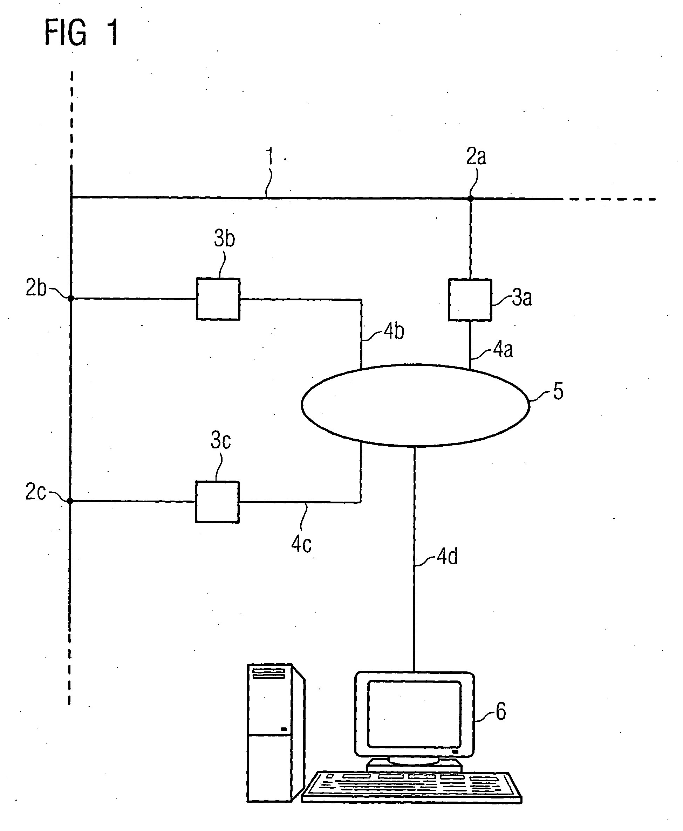

In Figur 1 ist mit 1 ein elektrisches Energieversorgungsnetz bezeichnet, von dem hier beispielhaft zwei Abschnitte, beispielsweise eine Sammelschiene und ein mit dieser verbundener Abzweig, dargestellt sind. An mehreren Messstellen 2a bis 2c des elektrischen Energieversorgungsnetzes 1 sind in Figur 1 nicht dargestellte Strom- und/oder Spannungswandler vorgesehen, die ausgangsseitig mit elektrischen Feldgeräten 3a bis 3c zum Erfassen der Elektroenergiequalität des elektrischen Energieversorgungsnetzes 1 in Verbindung stehen. Die elektrischen Feldgeräte 3a bis 3c sind ihrerseits über Datenleitungen 4ä bis 4c mit einem Kommunikationsnetzwerk 5, beispielsweise einem Ethernet-Netzwerk verbunden. An das Kommunikationsnetzwerk 5 ist außerdem eine zentrale Datenverarbeitungseinrichtung 6 über eine Kommunikationsleitung 4d angeschlossen.

Das in Figur 1 dargestellte System funktioniert wie im Folgenden erläutert: Mit den Feldgeräten 3a bis 3c werden über die nicht dargestellten Strom- und Spannungswandler Messwerte erfasst, die Wechselstrom und/oder Wechselspannungswerte an den jeweiligen Messstellen 2a, 2b und 2c des elektrischen Energieversorgungsnetzes 1 angeben. Die erfassten Messwerte werden daraufhin überprüft, ob eine Abweichung der Messwerte und damit auch der Wechselstrom- bzw. Wechselspannungswerte an den jeweiligen Messstellen 2a bis 2c des elektrischen Energieversorgungsnetzes vorliegt. Als Abweichung wird in diesem Fall ein Unterschied der Wechselstrom- bzw. Wechselspannungswerte von ihrem geforderten Verlauf angesehen. Anhand der aufgenommenen Messwerte bestimmen die elektrischen Feldgeräte 3a bis 3c eine mögliche Ursache der jeweiligen Abweichung und geben diese in Form einer Ursachenzeichenfolge an. Zusätzlich kann vorgesehen sein, dass die elektrischen Feldgeräte auch mögliche Auswirkungen der Abweichungen an den jeweiligen Messstellen 2a bis 2c bestimmen und diese in Form einer Auswirkungszeichenfolge angeben. Die Ursachenzeichenfolge, gegebenenfalls die Auswirkungszeichenfolge und weitere aus den Messwerten erzeugte Zustandsparameter, die den jeweiligen Zustand des elektrischen Energieversorgungsnetzes an den einzelnen Messstellen 2a bis 2c angeben, dienen als Grundlage zum Erzeugen eines Datensatzes, der die erkannte Abweichung näher spezifiziert. Die Feldgeräte erzeugen solche Datensätze und übermitteln sie daraufhin über die Datenleitungen 4a bis 4c an das Kommunikationsnetzwerk 5. Handelt es sich bei dem Kommunikationsnetzwerk 5 beispielsweise um ein Ethernet-Netzwerk, so kann diese Datenübermittlung gemäß dem Standard IEC 61850, der die Kommunikation von Feldgeräten betrifft, erfolgen.

Die einzelnen Datensätze der jeweiligen Feldgeräte 3a bis 3c können zu einem Gesamtdatensatz zusammengefasst werden, mit dem eine Übersicht über alle betroffenen Messstellen des elektrischen Energieversorgungsnetzes gegeben werden kann. Dies kann entweder in einem der Feldgeräte 3a bis 3c oder in der zentralen Datenverarbeitungseinrichtung 6 geschehen. Letztendlich werden entweder die einzelnen Datensätze oder ein von einem der Feldgeräte 3a bis 3c erzeugter Gesamtdatensatz an die Datenverarbeitungseinrichtung 6 übertragen, auf der eine weitere Anzeige und Auswertung der erkannten Abweichung von der Elektroenergiequalität durchgeführt werden kann.

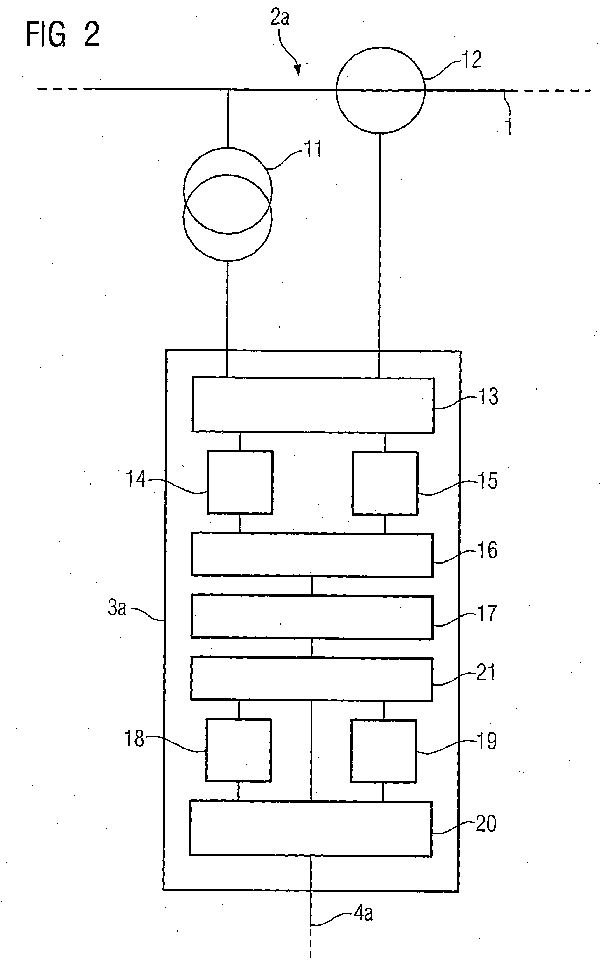

Figur 2 zeigt ein beispielhaft das Feldgerät 3a in detaillierter Darstellung. Das elektrische Feldgerät 3a ist über einen Spannungswandler 11 und einen Stromwandler 12 mit einer Messstelle 2a° des elektrischen Energieversorgungsnetzes 1 verbunden. Eingangsseitig weist das elektrische Feldgerät 3a eine Messeinrichtung 13 auf, die mit dem Spannungswandler 11 und dem Stromwandler 12 in Verbindung steht und ausgangsseitig mit einer Recheneinheit 14 und einer Schätzeinheit 15 verbunden ist. Die Recheneinheit 14 und die Schätzeinheit 15 sind ihrerseits ausgangsseitig mit einem Differenzbilder 16 verbunden. Der Differenzbilder 16 steht seinerseits ausgangsseitig mit einer Ereigniserkennungseinrichtung 17 in Verbindung. Der Ereigniserkennungseinrichtung 17 ist ausgangsseitig eine Parameterberechnungseinrichtung 21 nachgeordnet.

Der Parameterberechnungseinrichtung 21 ist ausgangsseitig zum einen eine Ursachenerkennungseinheit 18 und zum anderen eine Auswirkungserkennungseinrichtung 19 nachgeordnet. Die Ursachenerkennungseinheit 18 und die Auswirkungserkennungseinrichtung 19 sind ihrerseits ausgangsseitig mit einer Ausgabeeinheit 20 verbunden, welche wiederum an ihrem Ausgang mittels einer Datenschnittstelle über die Datenleitung 4a mit dem in Figur 1 dargestellten Kommunikationsnetzwerk 5 verbunden ist.

Handelt es sich bei dem elektrischen Energieversorgungsnetz 1 um ein mehrphasiges, beispielsweise ein dreiphasiges, Energieversorgungsnetz, so sind entsprechend für jede Phase ein Strom- und ein Spannungswandler und eine entsprechende Anzahl von Funktionskomponenten des elektrischen Feldgerätes 3a, wie z.B. der Messeinrichtung 13, vorgesehen.

Die Funktionsweise des in Figur 2 dargestellten Feldgerätes 3a wird im Folgenden näher erläutert: In dem elektrischen Energieversorgungsnetz 1 an der Messstelle 2a auftretende Wechselstrom- und/oder Wechselspannungswerte werden über den Stromwandler 12 bzw. den Spannungswandler 11 in zu den Wechselstromwerten bzw. Wechselspannungswerten proportionale Messwerte umgewandelt und von der Messeinrichtung 13 im Feldgerät 3a erfasst. Beispielsweise kann in der Messeinrichtung 13 auch eine Analog-/Digitalwandlung der Messwerte vorgenommen werden. Die Analog-/Digitalwandlung kann allerdings auch außerhalb des elektrischen Feldgerätes 3a stattfinden.

Die aufgenommenen Messwerte werden an die Recheneinheit 14 weitergegeben, die aus den Messwerten einen Mittelwert, wie z.B. einen RMS-Wert (root mean square) oder einen Effektivwert, erzeugt. Hierzu ist es von Vorteil, wenn die Messwerte während einer Zeitdauer von beispielsweise jeweils einer halben Schwingungsperiode des Wechselstromes bzw. der Wechselspannung aufgenommen werden und aus den während dieser halben Schwingungsperiode aufgenommenen Messwerten der Mittelwert gebildet wird. Auf diese Weise sind einerseits ausreichend Messwerte für eine verlässliche Berechnung vorhanden und andererseits kann verhältnismäßig schnell der Mittelwert bestimmt sein.

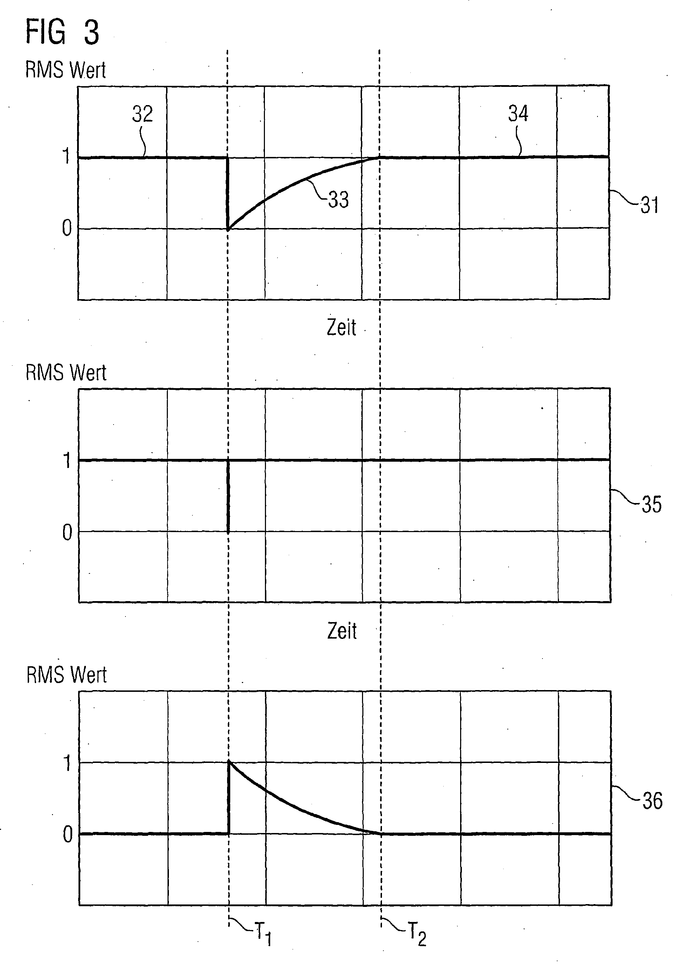

Mit der Messeinrichtung 13 steht ebenfalls die Schätzeinrichtung 15 in Verbindung, die aufgrund bereits vergangener Messwerte eine Schätzung abgibt, welchen Wert der Mittelwert erwartungsgemäß annehmen müsste. Hierzu kann beispielsweise ein durch elektronische oder digitale Filter implementiertes Signalmodell mit einem Gleichspannungsanteil und einem exponentiellen Anteil verwendet werden. Der Gleichspannungsanteil erfasst die gleich bleibenden Anteile des Mittelwertes, während der exponentielle Anteil exponentiell ansteigende oder abfallende Anteile des Mittelwertes ermittelt. Zur Erläuterung der Funktionsweise der Schätzeinrichtung 15 soll zunächst Figur 3 betrachtet werden.

In Figur 3 sind drei Diagramme dargestellt. In dem oberen Diagramm 31 ist mit einer fett durchgezogenen Linie der Verlauf eines in der Recheneinheit 14 bestimmten Mittelwertes der Wechselspannung oder des Wechselstromes dargestellt. Der zeitliche Verlauf des Mittelwertes lässt sich drei Abschnitte unterteilen. Der erste Abschnitt 32 zeigt einen konstanten Verlauf des RMS-Wertes. Zum durch eine erste gestrichelte Linie angedeuteten Zeitpunkt T1 fällt der Wert des Mittelwertes sprunghaft ab, um dann in einem zweiten Abschnitt 33 des Verlaufes des Mittelwertes in exponentieller Weise wieder anzusteigen. Ab dem durch eine weitere gestrichelte Linie angedeuteten Zeitpunkt T2 hat der Wert des Mittelwertes wieder seinen ursprünglichen Wert erreicht und verläuft in einem dritten Abschnitt 34 wieder konstant.

In dem in Figur 3 dargestellten mittleren Diagramm 35 ist der Verlauf eines Gleichanteils des zeitlichen Verlaufes des im ersten Diagramm dargestellten Mittelwertes aufgetragen. Man erkennt einen im Wesentlichen konstanten Verlauf, der nur zum Zeitpunkt T1 einen sprunghaften Ausschlag aufweist.

In Figur 3 unteren Diagramm 36 ist schließlich der exponentielle Anteil des in Diagramm 31 dargestellten zeitlichen Verlaufs des Mittelwertes aufgetragen. Man erkennt, dass der exponentielle Anteil in den Abschnitten 32 und 34 bei Null liegt, d.h., in diesen Abschnitten enthält der Verlauf des Mittelwertes keinen exponentiellen Anteil. Lediglich im Abschnitt 33 zwischen den Zeitpunkten T1 und T2 ist ein exponentiell verlaufender Anteil des zeitlichen Mittelwertverlaufes aus dem oberen Diagramm vorhanden. Zieht man den exponentiellen Verlauf vom Gleichanteil ab, so ergibt sich wiederum der im oberen Diagramm 31 angezeigte zeitlichen Verlauf des Mittelwertes.

Die Schätzeinheit 15 (siehe Figur 2) funktioniert folgendermaßen. Im ersten Abschnitt 32 des zeitlichen Verlaufs des Mittelwertes erkennt die Schätzeinheit 15 lediglich einen Gleichanteil des zeitlichen Verlaufes und sagt daher als Erwartungswert eine Fortsetzung des Gleichanteils mit demselben Wert voraus. Sowohl die Recheneinheit 14 als auch die Schätzeinheit 15 übergeben ihre Ergebnisse an den Differenzbilder 16, der den Erwartungswert von dem tatsächlichen Mittelwert abzieht. Im Falle des ersten Abschnittes 32 ergibt sich als Differenz ein Wert nahe Null, so dass die Ereigniserkennungseinrichtung 17 keine Abweichung des Mittelwertes von seinem erwarteten Verlauf angibt und somit kein Ereignissignal erzeugt. Dazu kann die Ereigniserkennungseinrichtung beispielsweise einen Schwellenwertvergleich durchführen. Liegt die von dem Differenzbilder bestimmte Differenz über einer vorgebbaren Schwelle, z.B. 5% des bisherigen Wertes des Mittelwertes, so erkennt die die Ereigniserkennungseinrichtung 17 eine Abweichung und erzeugt ein Ereignissignal.

Zum Zeitpunkt T1 vollführt der tatsächliche Mittelwert eine sprunghafte Änderung. Die Schätzeinrichtung 15 bestimmt allerdings zum Zeitpunkt T1 auf Grundlage der diesem Zeitpunkt T1 vorangegangenen Mittelwerte im Bereich 32 einen weiterhin konstant verlaufenden Erwartungswert. Somit ergibt sich im Differenzbilder 16 ein Differenzwert ungleich Null, der der Ereigniserkennungseinrichtung 17 zugeführt wird. Im vorliegenden Fall sei angenommen, dass die berechnete Differenz größer als der vorgegebene Schwellenwert ist, so dass von der Ereigniserkennungseinrichtung 17 eine Abweichung erkannt und dementsprechend ein Ereignissignal ausgegeben wird.

Da der weitere Verlauf des tatsächlichen Mittelwertes in exponentieller Weise verläuft, wird der Schätzbaustein neu initialisiert und gibt nun Erwartungswerte aus, die einem exponentiellen Verlauf folgen. Weil nun der von der Recheneinheit 14 abgegebene tatsächliche Mittelwert und der von der Schätzeinheit 15 abgegebene Erwartungswert wieder übereinstimmen, wird in dem Differenzbilder 16 eine Differenz nahe Null berechnet, die unterhalb des von der Ereigniserkennungseinrichtung 17 verwendeten Schwellenwertes liegt. Nach Erkennung der Abweichung zum Zeitpunkt T1 werden während einer vorgebbaren Messdauer weitere Messwerte aufgenommen, wobei auch aus diesen weiteren Messwerten Mittelwerte gebildet werden. Folglich werden also beispielsweise nach Abgabe des Ereignissignals durch die Ereigniserkennungseinrichtung 17 während einer vorgegebenen Messdauer von 5 Sekunden weitere Messwerte aufgenommen, wobei auch aus den weiteren Messwerten jeweils für Zeitfenster mit der Dauer einer halben Schwingungsperiode des Wechselstromes oder der Wechselspannung Mittelwerte gebildet werden.

Aus den während dieser Messdauer aufgenommenen Messwerten wird außerdem in einer der Ereigniserkennungseinrichtung 17 nachgeordneten Parameterberechnungseinrichtung 21 ein Satz von Züstandsparametern gebildet, die den Zustand des elektrischen Energieversorgungsnetzes an der Messstelle 2a während der Ereigniszeitdauer beschreiben. Hierauf wird später noch genauer eingegangen.

Im weiteren Verlauf des Mittelwertes nimmt der Mittelwert in Abschnitt 34 (Fig. 3) wieder den ursprünglichen konstanten Wert an, da hier der exponentielle Anteil des Verlaufes wieder abgeklungen ist. Folglich liefert die Schätzeinheit 15 weiter Erwartungswerte, die mit dem tatsächlichen Mittelwert, der von der Recheneinheit 14 abgegeben wird, übereinstimmen. Daher wird in Abschnitt 34 vom Differenzbilder 16 eine Differenz nahe Null ermittelt, was in der Ereigniserkennungseinrichtung 17 dazu führt, dass kein Ereignissignal abgegeben wird.

Die von der Parameterberechnungseinrichtung 21 während der Messdauer berechneten Zustands-Parameter können beispielsweise symmetrische Komponenten, Oberschwingungsanteile sowie Frequenzen, Phasen und Amplituden der Wechselstrom- bzw. Wechselspannungswerte sein. Sie beschreiben den Zustand des Energieversorgungsnetzes an der Messstelle 2a. Die Zustands-Parameter werden der Ursachenerkennungseinheit 18 zugeführt. Die Ursachenerkennungseinheit 18 weist eine Datenbank auf, die mögliche Ursachen für Abweichungen des Wechselstrom- bzw. Wechselspannungsverlaufes an der Messstelle 2a enthält und jeder möglichen Ursache jeweils einen Vergleichssatz von Zustands-Parametern zuordnet. Der Parametersatz, der von der Parameterberechnungseinrichtung 21 berechnet worden ist, wird folglich mit den Vergleichssätzen in der Datenbank verglichen. Bei Übereinstimmung eines Vergleichsatzes mit dem Parametersatz kann auf die der Abweichung zugrunde liegende Ursache geschlossen werden. Aus der Datenbank wird in diesem Fall eine Ursachenzeichenfolge ausgelesen, die die Ursachenerkennungseinheit ausgangsseitig bereitstellt.

Die elektronische Datenbank der Ursachenerkennungseinheit 18 kann beispielsweise derart aufgebaut sein, wie durch folgende Tabelle angegeben wird:

| Ursache | RMS (der Wechsel-Spannung) | Anzahl von erzeugten Ereignissignalen | Symmetrische Komponenten | Harmonische | Dauer |
|---|---|---|---|---|---|
| Fehler (z.B. Kurzschluss) | -steiler Abfall, | 2 | symmetrisch oder unsymmetrisch | Kein Einfluss | sehr lang (mehrere Perioden) |
| | -stabiler linearer Verlauf, | | | | |
| | -steiler Wiederanstieg | | | | |
| Motorstart | -steiler Abfall, | 1 | Symmetrisch | Kein Ein- | sehr lang (mehrere Perioden) |
| | -Vorliegen eines Minimums, | | | fluss | |
| | -exponentieller Wiederanstieg | | | | |
| Transformatorinbetriebnahme | -steiler Abfall, | 1 | Unsymmetrisch | Anteil der 2. Harmonischen größer 10% | sehr lang |
| | - Vorliegen eines Minimums, | | | | |
| | -exponentieller Wiederanstieg | | | | |
| Sich fortsetzender Fehler | - steiler Abfall, | >2 | symmetrisch oder unsymmetrisch | Kein Einfluss | sehr lang (mehrere Perioden) |
| | - mehrfaches Auftreten stabiler linearer Verläufe, | | | | |
| | -steiler Wiederanstieg | | | | |
| Selbstverlöschender Fehler | -steiler Abfall, | 1 | unsymmetrisch | Kein Einfluss | sehr kurz |
| | -Vorliegen eines Minimums, | | | | |
| | -exponentieller Wiederanstieg | | | | |

Geht man nach der dargestellten Tabelle, so würde die Ursachenerkennungseinheit 18 anhand des in dem oberen Diagramm 31 in Figur 3 dargestellten zeitlichen Verlauf des Mittelwertes in Verbindung mit weiteren berechneten Zustandsparametern als Ursache das Starten eines Elektromotors erkennen und folglich als Ursachenzeichenfolge z.B. "Start eines Elektromotors" ausgeben.

Neben der Ermittlung einer Ursache für die aufgetretene Abweichung können auch Auswirkungen der aufgetretenen Abweichung bestimmt werden. Dies erfolgt in der Auswirkungserkennungseinrichtung 19, an die ebenfalls der Parametersatz der Zustands-Parameter übergeben wird. Die Auswirkungserkennungseinrichtung 19 ermittelt beispielsweise anhand der Zustands-parameter "Betrag der Abweichung" und "Ereignisdauer" (= Dauer der Abweichung), die in einem Diagramm mit ITIC-Referenzkurven aufgetragen werden, die Schwere der Abweichungen und gibt mögliche Schädigungen von an das Energieversorgungsnetz, angeschlossenen Verbrauchern an, insbesondere Verbrauchern des informationstechnischen Bereichs. Diese Auswirkungen stellt die Auswirkungserkennungseinrichtung 19 in Form einer Auswirkungszeichenfolge ausgangsseitig bereit. Sowohl die Ursachenzeichenfolge als auch die ggf. erzeugte Auswirkungszeichenfolge als auch.die in der Parameterberechnungseinrichtung 21 erzeugten Zustands-Parameter dienen als Grundlage zur Erzeugung eines Datensatzes. Dieser Datensatz kann entweder konkret die Ursachenzeichenfolge, die Auswirkungs-zeichenfolge und die Zustands-Parameter oder von ihnen abgeleitete Informationen enthalten. Dieser Datensatz kann über die Datenschnittstelle der Ausgabeeinheit 20 und die Kommunikationsleitung 4a an das Kommunikationsnetzwerk 5, das beispielsweise ein Ethernetnetzwerk sein kann, übertragen werden und beispielsweise von der in Figur 1 dargestellten zentralen Datenverarbeitungseinrichtung 6 empfangen werden. Die zentrale Datenverarbeitungseinrichtung 6 kann den Datensatz einem Benutzer anzeigen, der hierdurch umfassend über die aufgetretene Abweichung informiert wird, ohne notwendigerweise weitere Auswertungen vornehmen zu müssen.

Obwohl die im Zusammenhang mit Figur 2 erläuterten Komponenten des elektrischen Feldgerätes 3a in Form separater Funktionsblöcke dargestellt sind, können sie auch durch eine Mikroprozessoreinrichtung des elektrischen Feldgerätes durchgeführt werden, der eine entsprechende Software bereitgestellt wird, mit der die einzelnen Verfahrensschritte durchgeführt werden.

## Patentansprüche

1. Verfahren zum Erzeugen eines Datensatzes, der eine Abweichung von an einer Messstelle (2a, 2b, 2c) eines Energieversorgungsnetzes (1) vorliegenden Wechselstrom- und/oder Wechselspannungswerten von ihrem erwartungsgemäßen zeitlichen Verlauf angibt, wobei bei dem Verfahren folgende Schritte durchgeführt werden:
- Aufnehmen von die Wechselstrom- und/oder Wechselspannungswerte an der Messstelle (2a, 2b, 2c) des Energieversorgungsnetzes angebenden Messwerten;
**gekennzeichnet durch** die folgenden weiteren Schritte:
- Erzeugen eines Ereignissignals, wenn die Messwerte von ihrem erwartungsgemäßen zeitlichen Verlauf abweichen; wobei
- die Messwerte jeweils während einer Mittelungsdauer aufgenommen werden und aus den während der Mittelungsdauer aufgenommenen Messwerten ein Mittelwert gebildet wird und
- eine Differenz zwischen diesem Mittelwert und einem Erwartungswert gebildet wird, wobei der Erwartungswert einen erwarteten Wert des Mittelwertes angibt, der hinsichtlich dem aktuellen Mittelwert zeitlich vorausgegangener Mittelwerte unter Nutzung eines **durch** elektronische oder digitale Filter implementierten Signalmodells mit einem Gleichspannungsanteil und einem exponentiellen Anteil bestimmt worden ist, und
- das eine Abweichung des Mittelwertes angebende Ereignissignal erzeugt wird, wenn die Differenz einen vorgegebenen Schwellenwert übersteigt,
- im Falle eines vorliegenden Ereignissignals Ermitteln eines Parametersatzes von einen Zustand des Energieversorgungsnetzes (1) an der Messstelle (2a, 2b, 2c) beschreibenden Zustands-Parametern aus den Messwerten und diesen Messwerten während einer vorgebbaren Messdauer folgenden weiteren Messwerten und Zuordnen zumindest einiger Zustands-Parameter des Parametersatzes zu einer zugehörigen, eine Ursache der Abweichung angebenden Ursachenzeichenfolge und
- Erzeugen des Datensatzes aus zumindest dem Parametersatz und der Ursachenzeichenfolge.

2. Verfahren nach Anspruch 1,
**dadurch gekennzeichnet, dass**
- die Mittelungsdauer eine halbe Schwingungsperiode des gemessenen Wechselstromes oder der gemessenen Wechselspannung beträgt.

3. Verfahren nach einem der vorangehenden Ansprüche 1-2,
**dadurch gekennzeichnet, dass**
zum Zuordnen der Zustands-Parameter zu der Ursachenzeichenfolge
- eine elektronische Datenbank verwendet wird, in der jeweils einer Ursachenzeichenfolge ein dazugehörender Vergleichssatz von Zustands-Parametern zugeordnet ist, und
- der Datensatz aus derjenigen Ursachenzeichenfolge erzeugt wird, deren zugeordneter Vergleichssatz mit dem ermittelten Parametersatz übereinstimmt.

4. Verfahren nach einem der vorangehenden Ansprüche,
**dadurch gekennzeichnet, dass**
- der Parametersatz auch harmonische Schwingungen der Grundfrequenz der Messwerte angibt.

5. Verfahren nach einem der vorangehenden Ansprüche,
**dadurch gekennzeichnet, dass**
- bei einem dreiphasigen Energieversorgungsnetz der Parametersatz auch symmetrische Komponenten der Messwerte angibt.

6. Verfahren nach einem der vorangehenden Ansprüche,
**dadurch gekennzeichnet, dass**
- eine Ereignis-Zeitdauer bestimmt wird, während der die Abweichung vorliegt, und der Parametersatz auch die Ereignis-Zeitdauer angibt.

7. Verfahren nach einem der vorangehenden Ansprüche,
**dadurch gekennzeichnet, dass**
- unter Verwendung zumindest einiger Zustands-Parameter des Parametersatzes eine eine Auswirkung der Abweichung angebende Auswirkungs-Zeichenfolge erzeugt wird und
- der Datensatz unter Berücksichtigung der Auswirkungs-Zeichenfolge erzeugt wird.

8. Verfahren nach einem der vorangehenden Ansprüche,
**dadurch gekennzeichnet, dass**
- das Verfahren an mehreren Messstellen (2a, 2b, 2c) des Energieversorgungsnetzes (1) durchgeführt wird und
- die an den einzelnen Messstellen (2a, 2b, 2c) erzeugten Datensätze zu einem Gesamt-Datensatz zusammengefasst werden.

9. Feldgerät (3a) zum Erfassen der Elektroenergiequalität an einer Messstelle (2a) eines Energieversorgungsnetzes (1) mit
- einer Messeinrichtung (13) zum Erfassen von einen Wechselstrom und/oder eine Wechselspannung angebenden Messwerten,
- einer Recheneinheit (14) zum Bestimmen eines Mittelwertes der aufgenommenen Messwerte,
**gekennzeichnet durch**
- eine Schätzeinrichtung (15) zur Bildung eines Erwartungswertes, der einen erwarteten Wert des Mittelwertes angibt, der hinsichtlich dem aktuellen Mittelwert zeitlich vorausgegangener Mittelwerte unter Nutzung eines **durch** elektronische oder digitale Filter implementierten Signalmodells mit einem Gleichspannungsanteil und einem exponentiellen Anteil bestimmt worden ist,
- eine Ereigniserkennungseinrichtung (17), die bei einer Abweichung des Mittelwertes von dem Erwartungswert ein Ereignissignal erzeugt,
- eine Parameterberechnungseinrichtung (21), die bei vorliegendem Ereignissignal einen Parametersatz von Zustands-Parametern aus den Messwerten und diesen Messwerten während einer vorgebbaren Messdauer folgenden weiteren Messwerten bestimmt, wobei die Zustands-Parameter den Zustand des Energieversorgungsnetzes (1) an der Messstelle (2a) angeben,
- eine Ursachenerkennungseinheit (18), die bei vorliegender Abweichung dem Parametersatz eine eine Ursache der Abweichung angebende Ursachenzeichenfolge zuordnet, und
- eine Ausgabeeinheit (20), die einen Datensatz ausgibt, der unter Berücksichtigung zumindest einiger Zustands-Parameter des Parametersatzes und der Ursachenzeichenfolge gebildet ist.

10. Feldgerät (3a) nach Anspruch 9,
**dadurch gekennzeichnet, dass**
- die Ursachenerkennungseinheit (18) eine elektronische Datenbank aufweist, in der jeweils einer Ursachenzeichenfolge ein dazugehörender Vergleichssatz von Zustands-Parametern zugeordnet ist.

11. Feldgerät (3a) nach einem der Ansprüche 9 bis 10,
**dadurch gekennzeichnet, dass**
- das Feldgerät (3a) eine Auswirkungserkennungseinrichtung (19) aufweist, die anhand zumindest einiger der Zustands-Parameter eine eine Auswirkung der Abweichung angebende Auswirkungs-Zeichenfolge erzeugt.

12. Feldgerät (3a) nach einem der Ansprüche 9 bis 11,
**dadurch gekennzeichnet, dass**
- die Ausgabeeinheit (20) des Feldgerätes (3a) eine Datenschnittstelle aufweist, über die die der Datensatz ausgegeben wird.

13. Feldgerät (3a) nach Anspruch 12,
**dadurch gekennzeichnet, dass** die Datenschnittstelle eine Schnittstelle für ein IP-fähiges Netzwerk ist.

14. Feldgerät (3a) nach Anspruch 13,
**dadurch gekennzeichnet, dass**
- die Datenschnittstelle eine Ethernet-Schnittstelle ist.

15. System zum Erfassen der Elektroenergiequalität eines Energieversorgungsnetzes (1) mit mehreren Feldgeräten (3a, 3b, 3c) gemäß einem der Ansprüche 9 bis 14, wobei die Feldgeräte (3a, 3b, 3c) über ein Kommunikationsnetzwerk (5) miteinander verbunden sind.

16. System nach Anspruch 15,
**dadurch gekennzeichnet, dass**
- das Kommunikationsnetzwerk (5) ein IP-fähiges Netzwerk ist.

17. System nach Anspruch 16,
**dadurch gekennzeichnet, dass** das Kommunikationsnetzwerk ein Ethernet-Netzwerk ist.

18. System nach einem der Ansprüche 15 oder 17,
**dadurch gekennzeichnet, dass**
- eine zentrale Datenverarbeitungseinrichtung (6) mit dem Kommunikationsnetzwerk (5) in Verbindung steht.

## Claims

1. Method for production of a data record which indicates a discrepancy between alternating-current and/or AC voltage values at a measurement point (2a, 2b, 2c) in a power supply system (1) and their expected time profile, with the following steps being carried out in the method:
- recording of measured values which indicate the alternating-current and/or AC voltage values at the measurement point (2a, 2b, 2c) in the power supply system;
**characterized by** the following further steps:
- production of an event signal if the measured values differ from their expected time profile; wherein
- the measured values are in each case recorded during an averaging period and a mean value is formed from the measured values recorded during the averaging period, and
- the difference between this mean value and an expected value is formed, with the expected value indicating an expected value of the mean value which has been determined with respect to the actual mean value of mean values from previous times using a signal model implemented by electronic or digital filters and with a DC voltage component and an exponential component, and
- the event signal which indicates a discrepancy in the mean value is produced if the difference exceeds a predetermined threshold value,
- when an event signal is present, determination of a parameter set of state parameters which describe a state of the power supply system (1) at the measurement point (2a, 2b, 2c) from the measured values and from further measured values which follow these measured values during a predeterminable measurement period, and association of at least some of the state parameters in the parameter set with an associated cause character string which indicates a cause of the discrepancy, and
- production of the data record from at least the parameter set and the cause character string.

2. Method according to Claim 1,
**characterized in that**
- the averaging period is half the oscillation period of the measured alternating current or of the measured AC voltage.

3. Method according to either of the preceding Claims 1-2,
**characterized in that**
the state parameters are associated with the cause character string
- by using an electronic database in which in each case one cause character string is associated with an associated comparison set of state parameters, and
- the data record is produced from that cause character string whose associated comparison set matches the determined parameter set.

4. Method according to one of the preceding claims,
**characterized in that**
- the parameter set also indicates harmonic oscillations of the fundamental frequency of the measured values.

5. Method according to one of the preceding claims,
**characterized in that**
- in the case of a three-phase power supply system, the parameter set also indicates balanced components of the measured values.

6. Method according to one of the preceding claims,
**characterized in that**
- an event time duration is determined during which the discrepancy is present, and the parameter set also indicates the event time duration.

7. Method according to one of the preceding claims,
**characterized in that**
- at least some of the state parameters in the parameter set are used to produce an effective character string which indicates an effect of the discrepancy, and
- the data record is produced taking into account the effect character string.

8. Method according to one of the preceding claims,
**characterized in that**
- the method is carried out at a plurality of measurement points (2a, 2b, 2c) in the power supply system (1), and
- the data records produced at the individual measurement points (2a, 2b, 2c) are combined to form an overall data record.

9. Field device (3a) for recording the electrical power quality at a measurement point (2a) in a power supply system (1) having
- a measurement device (13) for recording measured values which indicate an alternating current and/or an AC voltage,
- a computation unit (14) for determining a mean value of the recorded measured values,
**characterized by**
- an estimation device (15) for forming an expected value indicating an expected value of the mean value which has been determined with respect to the actual mean value of mean values from previous times using a signal model implemented by electronic or digital filters and with a DC voltage component and an exponential component,
- an event identification device (17) which produces an event signal if there is a discrepancy between the mean value and the expected value,
- a parameter calculation device (21) which, when the event signal is present, determines a parameter set of state parameters from the measured values and from further measured values which follow these measured values during a predeterminable measurement period, with the state parameters indicating the state of the power supply system (1) at the measurement point (2a),
- a cause identification unit (18) which allocates a cause character string, indicating a cause of the discrepancy, to the parameter set when there is a discrepancy, and
- an output unit (20), which outputs a data record which is formed taking into account at least some of the state parameters in the parameter set and the cause character string.

10. Field device (3a) according to Claim 9,
**characterized in that**
- the cause identification unit (18) has an electronic database in which in each case one cause character string is associated with an associated comparison set of state parameters.

11. Field device (3a) according to one of Claims 9 to 10,
**characterized in that**
- the field device (3a) has an effect identification device (19) which uses at least some of the state parameters to produce an effect character string which indicates an effect of the discrepancy.

12. Field device (3a) according to one of Claims 9 to 11,
**characterized in that**
- the output unit (20) of the field device (3a) has a data interface via which the data record is emitted.

13. Field device (3a) according to Claim 12,
**characterized in that**
the data interface is an interface for an IP-compatible network.

14. Field device (3a) according to Claim 13,
**characterized in that**
- the data interface is an Ethernet interface.

15. System for recording the electrical power quality of a power supply system (1) having a plurality of field devices (3a, 3b, 3c) according to one of Claims 9 to 14, with the field devices (3a, 3b, 3c) being connected to one another via a communication network (5).

16. System according to Claim 15,
**characterized in that**
- the communication network (5) is an IP-compatible network.

17. System according to Claim 16,
**characterized in that**
the communication network is an Ethernet network.

18. System according to one of Claims 15 or 17,
**characterized in that**
- a central data processing facility (6) is connected to the communication network (5).

## Revendications

1. Procédé de production d'un jeu de données, qui indique un écart de valeurs de courant alternatif et/ou de tension alternative présentes en un point ( 2a, 2b, 2c ) de mesure d'un réseau ( 1 ) d'alimentation électrique à leur variation en fonction du temps à laquelle on s'attend, procédé dans lequel on effectue les stades suivants :
- enregistrement de valeurs de mesure indiquant les valeurs du courant alternatif et/ou de la tension alternative au point ( 2a, 2b, 2c ) de mesure du réseau d'alimentation électrique ; **caractérisé par** les autres stades suivants :
- production d'un signal d'évènement, lorsque les valeurs de mesure s'écartent de leur variation en fonction du temps à laquelle on s'attend ; dans lequel
- on enregistre les valeurs de mesure respectivement pendant une durée où l'on fait une moyenne et on forme une valeur moyenne à partir des valeurs de mesure enregistrées pendant la durée pendant laquelle on forme une valeur moyenne et
- on forme une différence entre cette valeur moyenne et une valeur à laquelle on s'attend, la valeur à laquelle on s'attend indiquant une valeur à laquelle on s'attend de la valeur moyenne, qui a été déterminée en considérant des valeurs moyennes précédant dans le temps la valeur moyenne présente, en utilisant un modèle de signal mis en oeuvre par des filtres électroniques ou numériques ayant une composante de tension continue et une composante exponentielle, et
- on produit le signal d'évènement indiquant un écart de la valeur moyenne, lorsque la différence dépasse une valeur de seuil prescrite,
- si un signal d'événement est présent, on détermine un jeu de paramètres d'état décrivant un état du réseau (1) d'alimentation électrique au point ( 2a, 2b, 2c ) de mesure à partir des valeurs de mesure et d'autres valeurs de mesure suivant ces valeurs de mesure pendant une durée de mesure pouvant être prescrite et on affecte au moins quelques paramètres d'état du jeu de paramètres à une suite de caractères de cause associés et indiquant une cause de l'écart et
- on produit le jeu de données constitué d'au moins le jeu de paramètres et de la suite de caractères de cause.

2. Procédé suivant la revendication 1,
**caractérisé en ce que**
- la durée pendant laquelle on fait la moyenne correspond à une demi-période d'oscillation du courant alternatif mesuré ou de la tension alternative mesurée.

3. Procédé suivant l'une des revendications 1 à 2 précédentes,
**caractérisé en ce que**
pour affecter les paramètres d'état à la suite de caractères de cause
- on utilise une base de données électronique, dans laquelle un jeu de comparaisons associé de paramètres d'état est affecté à une suite de caractères de cause, et
- le jeu de données est produit à partir de la succession de caractères de cause, dont le jeu de comparaisons affecté coïncide avec le jeu de paramètres déterminé.

4. Procédé suivant l'une des revendications précédentes,
**caractérisé en ce que**
- le jeu de paramètres indique aussi des harmoniques de la fréquence de base.

5. Procédé suivant l'une des revendications précédentes,
**caractérisé en ce que**
- pour un réseau d'alimentation électrique triphasé, le jeu de paramètres indique aussi des composantes symétriques des valeurs de mesure.

6. Procédé suivant l'une des revendications précédentes,
**caractérisé en ce que**
- on détermine une durée d'évènement pendant laquelle il y a l'écart et le jeu de paramètres indique aussi la durée de l'événement.

7. Procédé suivant l'une des revendications précédentes,
**caractérisé en ce que**
- en utilisant au moins quelques paramètres d'état du jeu de paramètres, on produit une suite de caractères d'effet indiquant un effet de l'écart et
- on produit le jeu de données en tenant compte de la suite de caractères d'effet.

8. Procédé suivant l'une des revendications précédentes,
**caractérisé en ce que**
- on effectue le procédé en plusieurs points ( 2a, 2b, 2c ) de mesure du réseau ( 1 ) d'alimentation électrique et
- on rassemble les jeux de données produits aux divers points ( 2a, 2b, 2c ) de mesure en un jeu de données global.

9. Appareil ( 3a ) de terrain pour la détection de la qualité de l'énergie électrique en un point ( 2a ) de mesure d'un réseau ( 1 ) d'alimentation électrique, comprenant
- un dispositif ( 13 ) de mesure, pour la détection de valeurs de mesures indiquant un courant alternatif et/ou une tension alternative,
- une unité ( 14 ) informatique de détermination d'une valeur moyenne des valeurs de mesure enregistrées,
**caractérisé par**
- un dispositif ( 15 ) d'évaluation pour la formation d'une valeur à laquelle on s'attend et qui indique une valeur à laquelle on s'attend de la valeur moyenne qui a été déterminée en considérant des valeurs moyennes précédant dans le temps la valeur moyenne instantanée, en utilisant un modèle de signal mis en oeuvre par des filtres électroniques ou numériques et ayant une composante de tension continue et une composante exponentielle,
- un dispositif ( 17 ) de détection d'évènement, qui produit un signal d'événement lorsque la valeur moyenne s'écarte de la valeur à laquelle on s'attend,
- un dispositif ( 21 ) de calcul de paramètres, qui, en présence d'un signal d'événement, détermine un jeu de paramètres d'état à partir des valeurs de mesure et d'autres valeurs de mesure suivant ces valeurs de mesure pendant une durée de mesure pouvant être prescrite, les paramètres d'état indiquant l'état du réseau ( 1 ) d'alimentation électrique au point ( 2a ) de mesure,
- une unité ( 18 ) de détection de cause, qui en présence d'un écart affecte au jeu de paramètres une suite de caractères de cause indiquant une cause de l'écart, et
- une unité ( 20 ) d'émission, qui émet un jeu de données, lequel est formé en prenant en compte au moins quelques paramètres d'état du jeu de paramètres et la suite de caractères de cause.

10. Appareil ( 3a ) de terrain suivant la revendication 9,
**caractérisé en ce que**
- l'unité ( 18 ) de détection de cause comporte une base de données électronique, dans laquelle un jeu de données associé de paramètres d'état est affecté respectivement à une suite de caractères de cause.

11. Appareil ( 3a ) de terrain suivant l'une des revendications 9 à 10,
**caractérisé en ce que**
- l'appareil ( 3a ) de terrain a un dispositif ( 19 ) de détection d'effet, qui, au moyen d'au moins certains des paramètres d'état, produit une suite de caractères d'effet indiquant l'effet de l'écart.

12. Appareil ( 3a ) de terrain suivant l'une des revendications 9 à 11,
**caractérisé en ce que**
- l'unité ( 20 ) d'émission de l'appareil ( 3a ) de terrain a une interface de données par laquelle le jeu de données est émis.

13. Appareil ( 3a ) de terrain suivant la revendication 12,
**caractérisé en ce que**
l'interface de données est une interface pour un réseau à aptitude IP.

14. Appareil ( 3a ) de terrain suivant la revendication 13,
**caractérisé en ce que**
- l'interface de données est une interface éthernet.

15. Système de détection de la qualité d'énergie électrique d'un réseau ( 1 ) d'alimentation électrique ayant plusieurs appareils ( 3a, 3b, 3c ) de terrain suivant l'une des revendications 9 à 14, dans lequel les appareils ( 3a, 3b, 3c ) de terrain sont reliés entre eux par un réseau ( 5 ) de communication.

16. Système suivant la revendication 15,
**caractérisé en ce que**
- le réseau ( 5 ) de communication est un réseau à aptitude IP.

17. Système suivant la revendication 16,
**caractérisé en ce que**
- le réseau de communication est un réseau éthernet.

18. Système suivant l'une des revendications 15 ou 17,
**caractérisé en ce que**
- un dispositif ( 6 ) central de traitement de données est en liaison avec le réseau ( 5 ) de communication.
